# EUROPEAN PATENT SPECIFICATION

(11) **EP 4 340 017 B1**
(45) Date of publication and mention of the grant of the patent: **30.07.2025**
(21) Application number: 23197330.6
(22) Date of filing: 14.09.2023
(51) Int. Cl.: H01L 23/373, H01L 23/538, H01L 23/498, H05K 7/20, H01L 25/07, H02M 7/487, H02M 7/00, H01L 23/48

(54) **PACKAGING DEVICE, PACKAGING MODULE, AND ELECTRONIC DEVICE**
VERPACKUNGSVORRICHTUNG, VERPACKUNGSMODUL UND ELEKTRONISCHE VORRICHTUNG
DISPOSITIF D'ENCAPSULATION, MODULE D'ENCAPSULATION ET DISPOSITIF ÉLECTRONIQUE

(30) Priority: 16.09.2022 CN 202211131844
(43) Date of publication of application: 20.03.2024
(73) Proprietor: Huawei Digital Power Technologies Co., Ltd., Shenzhen, 518043 (CN)
(72) Inventor: YU, Bo, Shenzhen, 518043 (CN); WANG, Xudong, Shenzhen, 518043 (CN); LI, Xin, Shenzhen, 518043 (CN)
(74) Representative: Epping - Hermann - Fischer

(56) References cited:
- US-A1- 2017 105 311
- US-A1- 2018 174 945
- US-A1- 2022 093 517

## Description

### TECHNICAL FIELD

This application relates to the field of semiconductor device technologies, and in particular, to a packaging device, a packaging module in which the packaging device is used, and an electronic device in which the packaging device or the packaging module is used.

### BACKGROUND

To meet increasingly high power requirements, a power semiconductor device, especially a power semiconductor device of a power supply type, is increasingly evolving towards lightness, thinness, shortness, and high power density. Therefore, a heat dissipation requirement for the power semiconductor device is increasingly high.

A direct bonded copper (DBC) substrate in an existing power semiconductor device includes an upper copper foil, a lower copper foil, and a ceramic insulation layer located between the upper copper foil and the lower copper foil. Currently, a commonly used material of the ceramic insulation layer is Al₂O₃. Although Al₂O₃ has low costs and a mature process, a thermal conductivity is low (only 24 W/mK), and a heat dissipation capability of the power semiconductor device using the Al₂O₃ ceramic insulation layer is limited. As a volume of the power semiconductor device is reduced and power density is increased, DBC made of Al₂O₃ with a low thermal conductivity has become one of bottlenecks that limit improvement of the heat dissipation capability of the power semiconductor device.

US 2022/093517 A1 discloses microelectronic assemblies including microelectronic components that are coupled together by direct bonding, as well as related structures and techniques. The document describes that a microelectronic assembly may include an interposer, including an organic dielectric material, and a microelectronic component coupled to the interposer by direct bonding. Further, the microelectronic assemblies may include a heat transfer structure, a TIM, a mold material, a microelectronic component, an underfill material and/or a support component. US 2017/105311 A1 relates to electronic modules, and more particularly to RF modules having free-formed, self-supported electrical interconnects. The document describes an electronic module and a method for making the electronic module, having free-formed, self-supported interconnect pillars that electrically connect electronic components on a cover substrate of the electronic module with electronic components on a base substrate of the electronic module.

### SUMMARY

In view of this, to resolve at least one of the foregoing defects, it is necessary to provide a packaging device with a high heat dissipation capability and low costs in embodiments of this application.

In addition, embodiments of this application further provide a packaging module to which the packaging device is applied and an electronic device to which the packaging device or the packaging module is used. The invention is defined by the appended claims.

A first aspect of this application provides a packaging device. The packaging device includes a first circuit substrate and a second circuit substrate. The first circuit substrate includes a first line layer and a first insulation layer that are sequentially stacked, and at least one first electronic component is disposed on the first circuit substrate. The second circuit substrate includes a second line layer and a second insulation layer that are sequentially stacked, and at least one second electronic component is disposed on the second circuit substrate. A thermal conductivity of the first insulation layer is higher than a thermal conductivity of the second insulation layer.

The first insulation layer and the second insulation layer with different thermal conductivities are targetedly configured, so that the first insulation layer with a high thermal conductivity can be configured for the first circuit substrate with high power or high power density, and the second insulation layer with a low thermal conductivity can be configured for the second circuit substrate with low power or low power density. Layouts of the first circuit substrate and the second circuit substrate are flexible, so that a heat dissipation capability of the packaging device can be improved to a maximum extent, and comprehensive costs of the packaging device can be reduced.

With reference to the first aspect, in some embodiments, the second line layer is electrically connected to the first line layer through a conducting wire. Alternatively, the first line layer is electrically connected to the second line layer by using an electrical connection layer, and the first line layer, the second line layer, and the electrical connection layer are of an integrated structure.

The first line layer may be electrically connected to the second line layer in different electrical connection manners, so as to implement an electrical connection between the first circuit substrate and the second circuit substrate. The first line layer and the second line layer may implement an electrical connection through the conducting wire (for example, a metal bonding wire), and the connection manner is simple. In addition, the conducting wire is soft, an electrical connection operation is convenient, and this facilitates flexible layouts of the first circuit substrate and the second circuit substrate. Alternatively, the first line layer and the second line layer may form an integrated structure by using the electrical connection layer, and the first line layer, the second line layer, and the electrical connection layer may be formed at one time (for example, the first line layer, the second line layer, and the electrical connection layer may be formed by etching a same metal layer). There is no need to perform etching separately, thereby simplifying process complexity and difficulty of etching the first line layer and the second line layer, and there is no need to solder conducting wires, thereby improving reliability of the packaging device.

With reference to the first aspect, in some embodiments, the first insulation layer and the second insulation layer are in contact with each other.

When the first circuit substrate and the second circuit substrate are arranged, the first insulation layer and the second insulation layer may be in contact with each other, so as to implement lateral heat conduction between the first circuit substrate and the second circuit substrate, thereby further improving the heat dissipation capability.

With reference to the first aspect, in some embodiments, the first insulation layer and the second insulation layer are of an integrated structure.

The first insulation layer and the second insulation layer form an integrated structure, so that flatness and stiffness of the integrated first insulation layer and second insulation layer can be improved. This facilitates etching of the first line layer and the second line layer. In addition, when a heat dissipation apparatus is subsequently assembled, the integrated first insulation layer and second insulation layer can effectively reduce a risk of forming a gap between the heat dissipation apparatus and the first circuit substrate and the second circuit substrate, and improve heat dissipation efficiency.

With reference to the first aspect, the second circuit substrate further includes a circuit substrate body and at least one opening that penetrates the circuit substrate body, and at least one first circuit substrate is disposed in each opening.

Although the thermal conductivity of the second insulation layer is low, but a price is low. The second circuit substrate is used as a whole, and the opening is formed on the second circuit substrate. The first circuit substrate with a high thermal conductivity is embedded in the opening, and this helps improve the heat dissipation capability of the packaging device and reduce the costs of the packaging device. In addition, the second circuit substrate is used as a whole, and the second line layer may complete forming of lines in different areas through one etching, thereby simplifying an etching process. There is no need to solder conducting wires in different areas to implement an electrical connection. In addition, the second circuit substrate is used as a whole, so that flatness and stiffness are high. When the packaging device is subsequently assembled with the heat dissipation apparatus, a risk of forming the gap between the heat dissipation apparatus and the first circuit substrate and the second circuit substrate can be effectively reduced, and the heat dissipation efficiency of the packaging device is improved.

With reference to the first aspect, in some embodiments, a material of the first insulation layer includes AlN or Si₃N₄, and a material of the second insulation layer includes Al₂O₃.

AlN or Si₃N₄ has a high thermal conductivity, but is expensive. Al₂O₃ has a low thermal conductivity, but is cheap. The two types of materials are combined, and the first insulation layer and the second insulation layer that are of the materials are targetedly configured based on power or power density of the first circuit substrate and the second circuit substrate, so that the heat dissipation capability of the packaging device can be significantly improved and the costs can be greatly reduced.

With reference to the first aspect, in some embodiments, the first circuit substrate further includes a first thermally conductive layer located on a surface that is of the first insulation layer and that is away from the first line layer, and the second circuit substrate further includes a second thermally conductive layer located on a surface that is of the second insulation layer and that is away from the second line layer.

Conduction of heat in the first circuit substrate and the second circuit substrate is facilitated, and the heat dissipation efficiency of the packaging device is further improved by adding the first thermally conductive layer and the second thermally conductive layer.

With reference to the first aspect, in some embodiments, a surface that is of the first thermally conductive layer and that is away from the first insulation layer is coplanar with a surface that is of the second thermally conductive layer and that is away from the second insulation layer, and the first thermally conductive layer and the second thermally conductive layer are of an integrated structure.

When the first circuit substrate and the second circuit substrate are assembled, the surface that is of the first thermally conductive layer and that is away from the first insulation layer may be set to be coplanar with the surface that is of the second thermally conductive layer and that is away from the second insulation layer. In this case, the first thermally conductive layer and the second thermally conductive layer are configured as the integrated structure, and when the packaging device is subsequently connected to the heat dissipation apparatus, flatness of a connection interface between the packaging device and the heat dissipation apparatus can be increased, and a risk of forming a gap on the connection interface can be reduced, so as to further improve the heat dissipation efficiency.

With reference to the first aspect, in some embodiments, a surface that is of the first thermally conductive layer and that is away from the first insulation layer is not coplanar with a surface that is of the second thermally conductive layer and that is away from the second insulation layer, and the first thermally conductive layer and the second thermally conductive layer are disposed opposite to each other.

When the first circuit substrate and the second circuit substrate are assembled, the surface that is of the first thermally conductive layer and that is away from the first insulation layer may be not coplanar with the surface that is of the second thermally conductive layer and that is away from the second insulation layer (for example, the first circuit substrate and the second circuit substrate are disposed in a stacked manner or staggered manner). Flexible layouts of the first circuit substrate and the second circuit substrate can be implemented. In this case, the first thermally conductive layer and the second thermally conductive layer are disposed opposite to each other, so that the packaging device implements double-sided heat dissipation.

With reference to the first aspect, in some embodiments, the packaging device further includes a package body. The package body packages the first circuit substrate and the second circuit substrate, and both the surface that is of the first thermally conductive layer and that is away from the first insulation layer and the surface that is of the second thermally conductive layer and that is away from the second insulation layer are exposed from the package body.

The first circuit substrate and the second circuit substrate may be protected by adding the package body.

With reference to the first aspect, in some embodiments, a first thermally conductive component is disposed on the surface that is of the first thermally conductive layer and that is away from the first insulation layer, and a second thermally conductive component is disposed on the surface that is of the second thermally conductive layer and that is away from the second insulation layer.

Subsequent assembly and connection between the packaging device and the heat dissipation apparatus are facilitated, and heat dissipation effect can be further improved by adding the first thermally conductive component and the second thermally conductive component.

With reference to the first aspect, in some embodiments, when the surface that is of the first thermally conductive layer and that is away from the first insulation layer is coplanar with the surface that is of the second thermally conductive layer and that is away from the second insulation layer, the first thermally conductive component and the second thermally conductive component are of an integrated structure.

The first thermally conductive component and the second thermally conductive component are configured as the integrated structure, so that flatness of the connection interface when the first thermally conductive component and the second thermally conductive component are subsequently connected to the heat dissipation apparatus can be improved, a risk that the gap occurs on the connection interface can be reduced, and the heat dissipation efficiency of the packaging device can be further improved.

A second aspect of embodiments of this application provides a packaging module. The packaging module includes the packaging device according to the first aspect of embodiments of this application and at least one heat dissipation apparatus. The at least one heat dissipation apparatus is located on a side that is of a first insulation layer and that is away from a first line layer and/or on a side that is of a second insulation layer and that is away from a second line layer.

Heat dissipation efficiency of the packaging device can be further improved by adding the heat dissipation apparatus on a surface of the packaging device. A first circuit substrate and a second circuit substrate may be flexibly arranged. When a surface that is of a first thermally conductive layer and that is away from the first insulation layer is coplanar with a surface that is of a second thermally conductive layer and that is away from the second insulation layer, only one heat dissipation apparatus may be disposed, so as to implement single-sided heat dissipation of the packaging device and help reduce an overall thickness of the packaging module. When the surface that is of the first thermally conductive layer and that is away from the first insulation layer is not coplanar with the surface that is of the second thermally conductive layer and that is away from the second insulation layer, at least two heat dissipation apparatuses may be disposed on the packaging device, so as to implement double-sided heat dissipation of the packaging device and improve heat dissipation efficiency of the packaging module.

A third aspect of embodiments of this application provides an electronic device. The electronic device includes a housing and the packaging device according to the first aspect of embodiments of this application or the packaging module according to the second aspect of embodiments of this application that is located in the housing.

A heat dissipation capability of the electronic device can be improved, and costs of the electronic device can be reduced by using the packaging device according to the first aspect of embodiments of this application or the packaging module according to the second aspect of embodiments of this application.

### BRIEF DESCRIPTION OF DRAWINGS

FIG. 1 is a schematic diagram of a structure of a packaging device according to an example out of the scope of this application;
FIG. 2 is a top view of a packaging device in which a first electronic component and a second electronic component are connected in parallel according to an example out of the scope of this application;
FIG. 3 is a top view of a packaging device in which a first electronic component and a second electronic component are connected in series according to an example out of the scope of this application;
FIG. 4 is a schematic diagram of a circuit topology structure of the packaging device in which the first electronic component and the second electronic component are connected in series in FIG. 3;
FIG. 5 is a schematic diagram of a structure of a packaging device according to another example out of the scope of this application;
FIG. 6 is a schematic diagram of a structure of a packaging device according to still another example out of the scope of this application;
FIG. 7 is a schematic diagram of a structure of a packaging device according to still another example out of the scope of this application;
FIG. 8 is a schematic diagram of a structure of a packaging device according to still another example out of the scope of this application;
FIG. 9 is a schematic diagram of a structure of a packaging device according to still another example out of the scope of this application;
FIG. 10 is a schematic diagram of a structure of a packaging device according to still another example out of the scope of this application;
FIG. 11 is a schematic diagram of a structure of a packaging device according to one embodiment of this application;
FIG. 12 is a sectional view of the packaging device in FIG. 11 cut along XII-XII.
FIG. 13 is a schematic diagram of a structure of a packaging device according to still another example out of the scope of this application;
FIG. 14 is a schematic diagram of a structure of a packaging module according to an embodiment of this application; and
FIG. 15 is a schematic diagram of a structure of an electronic device according to an embodiment of this application.

**List of reference numerals of main elements**

| | |
|---|---|
| Packaging device | 100, 200, 300, 400, 500, 600, 700 |
| First circuit substrate | 1, 1a, 1b, 1c, 1e |
| First line layer | 11, 11a |
| First insulation layer | 12 |
| First thermally conductive layer | 13, 13a |
| Second circuit substrate | 2, 2a, 2b, 2c, 2d, 2e |
| Second line layer | 21, 21a, 21d |
| Second insulation layer | 22, 22d |
| Second thermally conductive layer | 23, 23a, 23d |
| Circuit substrate body | 24 |
| Opening | 25 |
| First electronic component | 3 |
| Second electronic component | 4 |
| Package body | 5 |
| First thermally conductive component | 6 |
| Second thermally conductive component | 7 |
| Conducting wire | 8 |
| Electrical connection layer | 9 |
| Adhesive layer | 10 |
| Shell | 20 |
| Packaging module | 1000 |
| Heat dissipation apparatus | 1100 |
| Electronic device | 2000 |
| Housing | 2100 |

### DESCRIPTION OF EMBODIMENTS

The following describes examples and embodiments of this application with reference to accompanying drawings in examples and embodiments of this application. Unless otherwise specified, a data range in examples and embodiments of this application includes end values

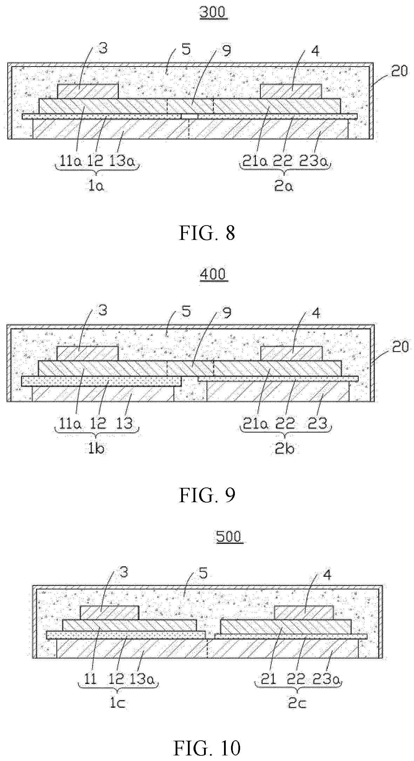

In addition, dashed lines in FIG. 8, FIG. 9, FIG. 10, FIG. 12, and FIG. 13 in the accompanying drawings of this application are merely used to distinguish between different structural components, and are not a part of the structural components in the figures.

A thermal conductivity of an insulation layer of a direct bonded copper (DBC) substrate in a common power semiconductor device is low, heat dissipation effect for a high-power electronic component is not satisfactory, and heat dissipation efficiency is low. In addition, the electronic component is prone to be damaged, and a heat dissipation requirement of a high-power-density power semiconductor device cannot be met.

To improve a heat dissipation capability of the power semiconductor device, the applicant attempts to prepare the power semiconductor device by using a DBC substrate made of an AlN material or an active metal brazing (AMB) substrate made of a Si₃N₄ material. In this case, the heat dissipation capability is improved. However, high costs of AlN and Si₃N₄ ceramic substrates significantly increase comprehensive costs of the power semiconductor device.

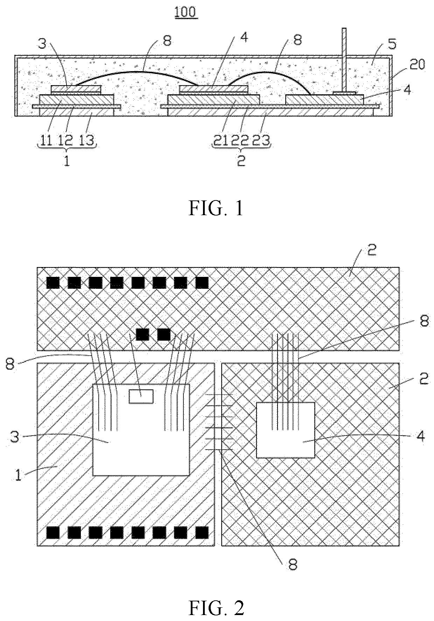

In view of this, refer to FIG. 1. To improve heat dissipation efficiency of a power semiconductor device and reduce comprehensive costs of the power semiconductor device, an example out of the scope of this application provides a packaging device 100. The packaging device 100 may be but is not limited to a power semiconductor device, and is configured to perform power processing, including frequency conversion, voltage conversion, current conversion, power management, and the like.

As shown in FIG. 1, the packaging device 100 includes a first circuit substrate 1 and a second circuit substrate 2. The first circuit substrate 1 includes a first line layer 11 and a first insulation layer 12 that are sequentially stacked, and at least one first electronic component 3 is disposed on the first circuit substrate 1. The second circuit substrate 2 includes a second line layer 21 and a second insulation layer 22 that are sequentially stacked, and at least one second electronic component 4 is disposed on the second circuit substrate 2. A thermal conductivity of the first insulation layer 12 is higher than a thermal conductivity of the second insulation layer 22.

The first electronic component 3 is located on the first line layer 11 and is electrically connected to the first line layer 11, and the second electronic component 4 is located on the second line layer 21 and is electrically connected to the second line layer 21. It may be understood that the first electronic component 3 may alternatively not be electrically connected to the first line layer 11, and the second electronic component 4 may alternatively not be electrically connected to the second line layer 21. Power or power density of the first electronic component 3 is greater than power or power density of the second electronic component 4. In a working process of the packaging device 100, both the first electronic component 3 and the second electronic component 4 generate heat. However, due to different power or different power density, generated heat varies. Therefore, high local heat exists in the packaging device 100. In some example out of the scope of this application, the power of the first electronic component 3 is greater than the power of the second electronic component 4. In this case, a heat dissipation capacity to be borne by the first circuit substrate 1 is greater than a heat dissipation capacity to be borne by the second circuit substrate 2, and the second circuit substrate 2 does not need to bear such a large heat dissipation capacity. Therefore, in this example out of the scope of this application, the first insulation layer 12 with a high thermal conductivity and the second insulation layer 22 with a low thermal conductivity are used, so that a heat dissipation capability of the first circuit substrate 1 can be improved. In addition, optimal heat dissipation effect of the packaging device 100 is implemented, and comprehensive costs of the packaging device 100 are minimized. It may be understood that, in another example, when the power density of the first electronic component 3 disposed on the first circuit substrate 1 is high, excessively high heat also exists. Therefore, the first insulation layer 12 with a high thermal conductivity may also be used to improve the heat dissipation capability of the first circuit substrate 1. In addition, the first insulation layer 12 and the second insulation layer 22 with different thermal conductivities may be configured for different types of electronic components, such as a wide bandgap device (a SiC wafer and a GaN wafer) and a Si-based wafer. The first insulation layer 12 with a high thermal conductivity is configured for the wide bandgap device. The wide bandgap device may allow a higher operating junction temperature, but at the same time, a wafer size at a same current level is smaller, in other words, the wide bandgap device has high power density, and has a high requirement for a heat dissipation capability. The first circuit substrate 1 with a high thermal conductivity can reduce thermal resistance of the wide bandgap device. In addition, compared with a traditional circuit substrate with a low thermal conductivity, when realizing same thermal resistance, the first circuit substrate 1 with a high thermal conductivity can reduce a required wafer area of the wide bandgap device and reduce costs of the wide bandgap device in the packaging device 100. In addition, the second insulation layer 22 with a low thermal conductivity and low costs is configured for the common Si-based wafer, so that the overall heat dissipation capability of the packaging device 100 can be ensured, and the costs of the packaging device 100 can be further reduced.

Both the first insulation layer 12 and the second insulation layer 22 have functions of insulation and heat conduction. A difference is that the first insulation layer 12 has a higher thermal conductivity than the second insulation layer 22, and has a higher heat dissipation capability. Materials of the first insulation layer 12 and the second insulation layer 22 are both insulating and heat-conducting materials, and may be insulation ceramics or high heat-conducting and insulating resin, but are not limited thereto. In some embodiments, both the first insulation layer 12 and the second insulation layer 22 may be insulation ceramic substrates. A material of the first insulation layer 12 may be AlN or Si₃N₄, and a material of the second insulation layer 22 may be Al₂O₃, but this is not limited. The first insulation layer 12 of an AlN or Si₃N₄ type has a high thermal conductivity (170 W/mK and 90 W/mK respectively) but high costs (at least 5 times costs of Al₂O₃). The second insulation layer 22 of an Al₂O₃ type has a low thermal conductivity (24 W/mK) but low costs. Therefore, in this example out of the scope of this application, based on heat consumption distribution in the packaging device 100, distribution of the first electronic component 3 and the second electronic component 4 in the packaging device 100 is targetedly optimized and the first insulation layer 12 and the second insulation layer 22 with different thermal conductivities are targetedly configured. In this case, the heat dissipation capability of the first circuit substrate 1 is improved, heat of the first electronic component 3 with high power is reduced, and normal heat dissipation of the second electronic component 4 with low power is ensured, so as to achieve the optimal heat dissipation effect of the packaging device 100 and reduce the comprehensive costs of the packaging device 100.

Both the first line layer 11 and the second line layer 21 may be metal line layers, and materials of the first line layer 11 and the second line layer 21 include but are not limited to copper, copper alloy, or the like.

As shown in FIG. 1, the first circuit substrate 1 further includes a first thermally conductive layer 13 located on a surface that is of the first insulation layer 12 and that is away from the first line layer 11, and the second circuit substrate 2 further includes a second thermally conductive layer 23 located on a surface that is of the second insulation layer 22 and that is away from the second line layer 21. The first thermally conductive layer 13 and the second thermally conductive layer 23 may be metal thermally conductive layers, and may include but are not limited to copper, copper alloy, or the like. It may be understood that the first thermally conductive layer 13 and the second thermally conductive layer 23 may alternatively be another heat-conducting material, for example, high heat-conducting resin.

In some examples, a surface that is of the first thermally conductive layer 13 and that is away from the first insulation layer 12 is coplanar with a surface that is of the second thermally conductive layer 23 and that is away from the second insulation layer 22, so that flatness of a connection interface when the packaging device 100 is subsequently connected to a heat dissipation apparatus can be improved, and a risk that a gap occurs on the connection interface because the first circuit substrate 1 and the second circuit substrate 2 are disposed separately is reduced, so as to further improve the heat dissipation effect of the packaging device 100.

In some examples, both the first circuit substrate 1 and the second circuit substrate 2 may be formed by a DBC board, an AMB board, or the like through line fabrication. A circuit substrate made of a DBC or AMB ceramic substrate not only has a high thermal conductivity, high bonding strength and the like, but also has a low coefficient of thermal expansion (in particular, a coefficient of thermal expansion of the AMB board is almost close to that of silicon), and can be applied to a high voltage operation without partial discharge. It may be understood that both the first thermally conductive layer 13 and the second thermally conductive layer 23 may have thick thicknesses, so as to facilitate subsequent connection to the heat dissipation apparatus to achieve ideal heat conduction effect. In some examples, for an area in which the first electronic component 3 is located and with high heat consumption, the first circuit substrate 1 is manufactured by using a ceramic material with high heat conduction, for example, an AlN-type DBC board or a Si₃N₄-type AMB board, so as to improve the heat dissipation capability of the first circuit substrate 1 and reduce thermal resistance of the first electronic component 3, to meet a heat dissipation requirement. However, an Al₂O₃-type DBC board with a low price is used in another area with low heat consumption, so as to improve the heat dissipation capability of the packaging device 100 and reduce costs.

It may be understood that the packaging device 100 may alternatively be in another module packaging form, for example, it is also applicable to change the DBC board or the AMB board to a module packaging form of another insulating and heat-conducting material, that is, a packaging device in which materials of the first insulation layer 12 and the second insulation layer 22 select another insulating and heat-conducting material (for example, the high heat-conducting and insulating resin). This packaging device includes but is not limited to an IP multimedia system (IMS) technology-based packaging technology, a single-tube packaging technology with built-in DBC, an intelligent power module (IPM) packaging technology, or the like.

In some examples, the first insulation layer 12 and the second insulation layer 22 are disposed in isolation, in other words, a specific gap is formed between the first insulation layer 12 and the second insulation layer 22, and there is no contact between the first insulation layer 12 and the second insulation layer 22. In this case, the first circuit substrate 1 and the second circuit substrate 2 may be disposed in isolation, as shown in FIG. 1. This design increases flexibility of layouts of the first circuit substrate 1 and the second circuit substrate 2, and quantities and areas of the first electronic component 3 and the second electronic component 4 may be arranged based on different areas. The first insulation layer 12 and the second insulation layer 22 of appropriate sizes may be used. In this way, the first insulation layer 12 and the second insulation layer 22 are disposed at intervals, so that sizes of the first circuit substrate 1 and the second circuit substrate 2 can be reduced as much as possible while a heat dissipation capability is ensured, thereby further reducing the costs and reducing a size of the packaging device 100. It may be understood that, in another example, the first insulation layer 12 and the second insulation layer 22 may alternatively be disposed in contact, but the first line layer 11 and the second line layer 21 are electrically isolated, so that lateral heat conduction between the first circuit substrate 1 and the second circuit substrate 2 can be implemented. This facilitates lateral conduction of heat from an area with high heat consumption to an area with low heat consumption, so as to further improve the overall heat dissipation efficiency of the packaging device 100.

It may be understood that the first circuit substrate 1 and the second circuit substrate 2 may be electrically connected, or may not be electrically connected. To facilitate electrical extraction of the packaging device 100, the first circuit substrate 1 and the second circuit substrate 2 are electrically connected. It may be further understood that a quantity of the first circuit substrate 1 and a quantity of the second circuit substrate 2 may be one or more. A plurality of first circuit substrates 1 may be electrically connected, and a plurality of second circuit substrates 2 may also be electrically connected. For electronic components with different power or areas with different power density, the first insulation layer 12 and the second insulation layer 22 with different thermal conductivities are targetedly configured, so that layout flexibility of the first circuit substrate 1 and the second circuit substrate 2 can be improved.

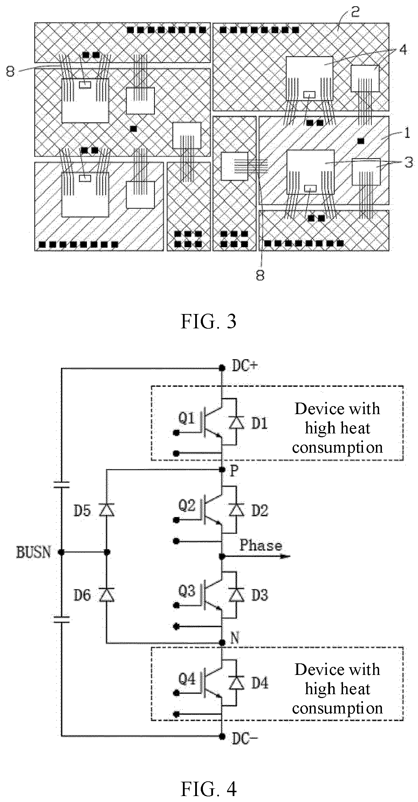

Refer to FIG. 1 and FIG. 2 again. Each of the first electronic component 3 and the second electronic component 4 may include one or more active components, for example, an active chip, including but not limited to a power chip, a digital chip, a radio frequency chip, and the like. In some examples, each of the first electronic component 3 and the second electronic component 4 may include power chips such as an insulated gate bipolar transistor (IGBT), silicon carbide (SiC), and gallium nitride (GaN). It may be understood that each of the first electronic component 3 and the second electronic component 4 may further include one or more passive components, and the passive components include but are not limited to a resistor, a capacitor, an inductor, a filter, a coupler, and the like. Back surfaces (in other words, non-active surfaces) of the first electronic component 3 and the second electronic component 4 may be disposed on the first line layer 11 and the second line layer 21 respectively by using a mounting method, and may be respectively mounted on surfaces of the first line layer 11 and the second line layer 21 in a welding manner. It may be understood that the first electronic component 3 and the second electronic component 4 may alternatively be respectively mounted on the surfaces of the first line layer 11 and the second line layer 21 in a sintering manner. Refer to FIG. 2 and FIG. 3. The first electronic component 3 and the second electronic component 4 may be connected in series and/or in parallel. A connection line is provided among the first circuit substrate 1, the second circuit substrate 2, the first electronic component 3, and the second electronic component 4 based on different electrical connection forms.

As shown in FIG. 2, in the packaging device 100, when the first electronic component 3 and the second electronic component 4 need to be connected in parallel, the first line layer 11 and the second line layer 21 need to be electrically connected, for example, an insulated gate bipolar transistor (IGBT) and a diode need to be connected in parallel. An IGBT chip as the first electronic component 3 is a device with high heat consumption, and the diode as the second electronic component 4 is a device with low heat consumption. A corresponding layout and connection manner is shown in FIG. 2. The IGBT chip with high heat consumption is arranged on the first circuit substrate 1 (that is, the DBC board with high heat conduction), and a diode chip with low heat consumption is arranged on the second circuit substrate 2 (that is, the Al₂O₃-type DBC board). Due to a parallel connection relationship between the first electronic component 3 and the second electronic component 4, a horizontally spanned conducting wire 8 (which is usually an aluminum or copper bonding wire) needs to be formed between the first circuit substrate 1 and the second circuit substrate 2 to electrically connect the first line layer 11 to the second line layer 21, and this connection manner is simple. In addition, the conducting wire 8 is soft, an electrical connection operation is convenient, and this facilitates flexible layouts of the first circuit substrate 1 and the second circuit substrate 2.

In the packaging device 100, when the first electronic component 3 and the second electronic component 4 need to be connected in series, a common I-type three-level neutral point clamped (NPC) circuit is used as an example. A schematic diagram of the circuit is shown in FIG. 4. For an NPC topology, heat consumption distribution of different chips is different. For a scenario that requires a bidirectional power transmission capability, high heat consumption or main heat dissipation bottleneck components (that is, the first electronic component 3) are an outer tube Q1/Q4 and an anti-parallel diode D1/D4 of the outer tube Q1/Q4. FIG. 3 is a schematic diagram of a module layout for the NPC topology. For a scenario in which the first electronic component 3 with high heat consumption and the second electronic component 4 with low heat consumption are connected in series, a jumper bonding wire does not need to be added between the first circuit substrate 1 and the second circuit substrate 2.

Refer to FIG. 1 again. The packaging device 100 further includes a package body 5 for packaging the first circuit substrate 1 and the second circuit substrate 2, and both the surface that is of the first thermally conductive layer 13 and that is away from the first insulation layer 12 and the surface that is of the second thermally conductive layer 23 and that is away from the second insulation layer 22 are exposed from the package body 5. It may be understood that the package body 5 further packages the first electronic component 3 and the second electronic component 4. The first circuit substrate 1, the second circuit substrate 2, the first electronic component 3, and the second electronic component 4 can be protected by adding the package body 5. In particular, the first electronic component 3 and the second electronic component 4 are less affected by factors such as mechanical stress, chemical contamination, light source irradiation, and the like. A material of the package body 5 is made of an insulating and heat-conducting packaging material, and generally includes insulating and heat-conducting resin. The insulating and heat-conducting resin may be selected from ABF resin, epoxy resin (epoxy resin), polyphenylene oxide (PPO), polyimide (PI), polyethylene terephthalate (PET), polyethylene naphthalate (PEN), and other resin. It may be understood that another insulating and heat-conducting material having characteristics such as a high thermal conductivity, good dielectric performance, a low coefficient of thermal expansion, high strength, high hardness, and nontoxic and harmless may also be applicable to the packaging device 100 provided in this embodiment of this application.

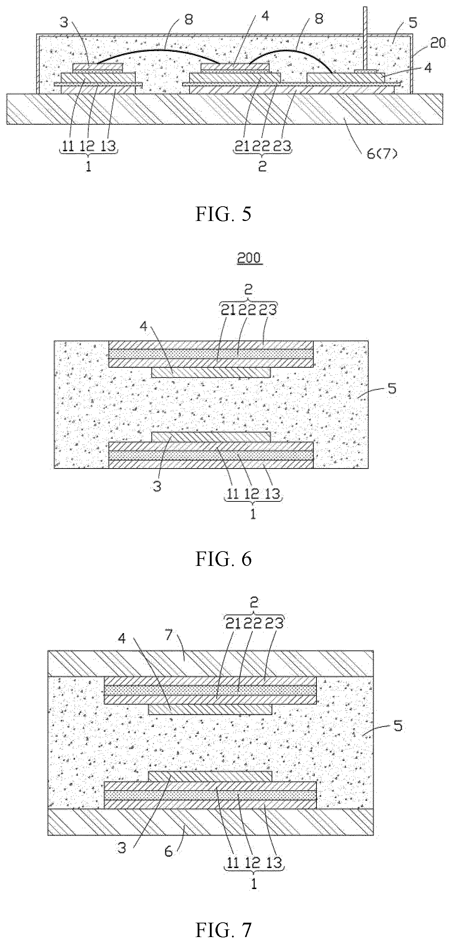

As shown in FIG. 5, the packaging device 100 may further include a first thermally conductive component 6 and a second thermally conductive component 7. The first thermally conductive component 6 is located on the surface that is of the first thermally conductive layer 13 and that is away from the first insulation layer 12, and the second thermally conductive component 7 is located on the surface that is of the second thermally conductive layer 23 and that is away from the second insulation layer 22. The first thermally conductive component 6 and the second thermally conductive component 7 that are thicker than the first thermally conductive layer 13 and the second thermally conductive layer 23 are added, so that subsequent assembly and connection of the packaging device 100 and the heat dissipation apparatus are facilitated, flatness of the connection interface between the packaging device 100 and the heat dissipation apparatus can be improved, the risk of forming the gap on the connection interface is reduced, and the heat dissipation efficiency of the packaging device 100 is further improved. In some example out of the scope of this application, as shown in FIG. 5, when the surface that is of the first thermally conductive layer 13 and that is away from the first insulation layer 12 is coplanar with the surface that is of the second thermally conductive layer 23 and that is away from the second insulation layer 22, the first thermally conductive component 6 and the second thermally conductive component 7 are of an integrated structure. The first thermally conductive component 6 and the second thermally conductive component 7 are a same thermally conductive layer (for example, a metal layer). The first thermally conductive component 6 and the second thermally conductive component 7 are configured as the integrated structure, so that flatness of a connection interface when the first thermally conductive component 6 and the second thermally conductive component 7 are subsequently connected to the heat dissipation apparatus can be improved, and the heat dissipation efficiency of the packaging device 100 can be further improved.

As shown in FIG. 1, the packaging device 100 may further include a shell 20. The surface that is of the first thermally conductive layer 13 and that is away from the first insulation layer 12 and the surface that is of the second thermally conductive layer 23 and that is away from the second insulation layer 22 are exposed from the shell 20, so as to facilitate subsequent assembly with the heat dissipation apparatus. A material of the shell 20 may be a heat-conducting material, and may be metal (for example, copper or aluminum), plastic, glass, or ceramic to which a heat-conducting filler is added, or the like. The heat-conducting filler may be a graphene particle, a metal particle, a metal oxide particle, or the like. The shell 20 may protect an internal structure of the packaging device 100, and improve a capability of the packaging device 100 to resist impact of an environmental factor.

According to the packaging device 100 provided in this example out of the scope of this application, the first insulation layer 12 and the second insulation layer 22 with different thermal conductivities are targetedly configured, so that the first insulation layer 12 with a high thermal conductivity may be configured for the first circuit substrate 1 with high power or high power density, and the second insulation layer 22 with a low thermal conductivity but low costs may be configured for the second circuit substrate 2 with low power or low power density. The first circuit substrate 1 and the second circuit substrate 2 are separately disposed, so that the layout flexibility of the first circuit substrate 1 and the second circuit substrate 2 is increased, the heat dissipation capability of the packaging device 100 can be improved to a maximum extent, and the comprehensive costs of the packaging device 100 can be reduced. In addition, the first circuit substrate 1 and the second circuit substrate 2 are separately prepared and processed, and thicknesses of the first circuit substrate 1 and the second circuit substrate 2 are allowed to be different. Therefore, arrangement and assembly of the first circuit substrate 1 and the second circuit substrate 2 are more flexible.

Refer to FIG. 6. Another example out of the scope of this application provides a packaging device 200. A difference between the packaging device 200 and the packaging device 100 in the foregoing example lies in that a surface that is of a first thermally conductive layer 13 and that is away from a first insulation layer 12 is not coplanar with a surface that is of a second thermally conductive layer 23 and that is away from a second insulation layer 22 in the packaging device 200, that is, a first circuit substrate 1 and a second circuit substrate 2 may be disposed in a staggered manner or stacked manner.

In some examples, the first circuit substrate 1 and the second circuit substrate 2 are disposed in the stacked manner along a thickness direction of the packaging device 200. The surface that is of the first thermally conductive layer 13 and that is away from the first insulation layer 12 and the surface that is of the second thermally conductive layer 23 and that is away from the second insulation layer 22 are away from each other (in other words, disposed oppositely). In this case, heat dissipation apparatuses may be separately connected to the surface of the first thermally conductive layer 13 and the surface of the second thermally conductive layer 23 that are away from each other, so as to achieve double-sided heat dissipation of the packaging device 200.

In another example out of the scope of this application, as shown in FIG. 7, a first thermally conductive component 6 and a second thermally conductive component 7 are respectively disposed on the surface of the first thermally conductive layer 13 and the surface of the second thermally conductive layer 23 that are away from each other. The first thermally conductive component 6 and the second thermally conductive component 7 are two independent components. This facilitates subsequent connection and assembly between the packaging device 200 and the heat dissipation apparatuses. Compared with the foregoing example, in the packaging device 200 in this example, the first circuit substrate 1 and the second circuit substrate 2 are disposed on different planes. In this way, optimal heat dissipation effect and minimum costs of the packaging device 200 are ensured, and a utilization rate of internal space of the packaging device 200 can be improved, thereby helping reduce a size of the packaging device 200. In addition, double-sided heat dissipation of the packaging device 200 may be further implemented, thereby further improving heat dissipation efficiency of the packaging device 200.

Refer to FIG. 8. Still another example out of the scope of this application provides a packaging device 300. A difference between the packaging device 300 and the packaging device 100 in the foregoing example lies in that the packaging device 300 includes a first circuit substrate 1a and a second circuit substrate 2a. The first circuit substrate 1a and the second circuit substrate 2a are of an integrated structure. The first circuit substrate 1a includes a first line layer 11a, a first insulation layer 12, and a first thermally conductive layer 13a that are sequentially stacked. The second circuit substrate 2a includes a second line layer 21a, a second insulation layer 22, and a second thermally conductive layer 23a that are sequentially stacked. An electrical connection layer 9 is disposed between the first line layer 11a and the second line layer 21a, and the first line layer 11a, the second line layer 21a, and the electrical connection layer 9 are of an integrated structure. The first thermally conductive layer 13a and the second thermally conductive layer 23a are of an integrated structure.

In some examples, the first line layer 11a, the second line layer 21a, and the electrical connection layer 9 are formed by etching a same metal layer.

In some examples, the first thermally conductive layer 13a and the second thermally conductive layer 23a are a same thermally conductive layer. For example, the first thermally conductive layer 13a and the second thermally conductive layer 23a may be formed by a same metal layer.

Compared with the foregoing example, in the packaging device 300 in this embodiment, the first circuit substrate 1a and the second circuit substrate 2a are configured as the integrated structure, to facilitate assembly of the packaging device 300. The first line layer 11a and the second line layer 21a are configured as the integrated structure, and the integrated structure may be formed by performing one etching process on the same metal layer, and no separate etching is required, thereby simplifying the etching process of the first line layer 11a and the second line layer 21a. In addition, when the first line layer 11a and the second line layer 21a need to be electrically connected, the electrical connection layer 9 between the first line layer 11a and the second line layer 21a may be retained during an etching process. There is no need to solder a conducting wire between the first line layer 11a and the second line layer 21a, thereby improving reliability of the packaging device 300.

Refer to FIG. 9. Still another example out of the scope of this application provides a packaging device 400. A difference between the packaging device 400 and the packaging device 300 in the foregoing example lies in that the packaging device 400 includes a first circuit substrate 1b and a second circuit substrate 2b. The first circuit substrate 1b and the second circuit substrate 2b are of an integrated structure. The first circuit substrate 1b includes a first line layer 11a, a first insulation layer 12, and a first thermally conductive layer 13 that are sequentially stacked. The second circuit substrate 2b includes a second line layer 21a, a second insulation layer 22, and a second thermally conductive layer 23 that are sequentially stacked. An electrical connection layer 9 is disposed between the first line layer 11a and the second line layer 21a, and the first line layer 11a, the second line layer 21a, and the electrical connection layer 9 are of an integrated structure.

In some examples, the first line layer 11a, the second line layer 21a, and the electrical connection layer 9 are formed by etching a same metal layer.

In some examples, if thicknesses of the first circuit substrate 1b and the second circuit substrate 2b need to be consistent, and thicknesses of the first insulation layer 12 and the second insulation layer 22 need to be inconsistent, thicknesses of the first thermally conductive layer 13 and the second thermally conductive layer 23 may be adjusted, so that the thicknesses of the first circuit substrate 1b and the second circuit substrate 2b are consistent.

Compared with the foregoing example, in the packaging device 400 in this example, when the thicknesses of the first insulation layer 12 and the second insulation layer 22 are inconsistent, the first line layer 11a and the second line layer 21a may be designed to be integrated, and the first thermally conductive layer 13 and the second thermally conductive layer 23 may be disposed independently, so that the first circuit substrate 1b and the second circuit substrate 2b form the integrated structure. In this case, the first line layer 11a and the second line layer 21a are etched once to simplify an etching process, and the integrated first line layer 11a and second line layer 21a facilitates assembly of the packaging device 400.

Refer to FIG. 10. Still another example out of the scope of this application provides a packaging device 500. A difference between the packaging device 500 and the packaging device 300 in the foregoing example lies in that the packaging device 500 includes a first circuit substrate 1c and a second circuit substrate 2c. The first circuit substrate 1c and the second circuit substrate 2c are of an integrated structure. The first circuit substrate 1c includes a first line layer 11, a first insulation layer 12, and a first thermally conductive layer 13a that are sequentially stacked. The second circuit substrate 2c includes a second line layer 21, a second insulation layer 22, and a second thermally conductive layer 23a that are sequentially stacked. The first thermally conductive layer 13a and the second thermally conductive layer 23a are of an integrated structure.

In some examples, the first thermally conductive layer 13a and the second thermally conductive layer 23a are a same thermally conductive layer. For example, the first thermally conductive layer 13a and the second thermally conductive layer 23a may be formed by a same metal layer.

In some examples, if thicknesses of the first circuit substrate 1c and the second circuit substrate 2c need to be consistent, and thicknesses of the first insulation layer 12 and the second insulation layer 22 need to be inconsistent, thicknesses of the first line layer 11 and the second line layer 21 may be adjusted, so that the thicknesses of the first circuit substrate 1c and the second circuit substrate 2c are consistent.

Compared with the foregoing example, in the packaging device 500 in this embodiment, when the thicknesses of the first insulation layer 12 and the second insulation layer 22 are inconsistent, the first thermally conductive layer 13a and the second thermally conductive layer 23a may be designed to be integrated, and the first line layer 11 and the second line layer 21 are disposed independently, so that the first circuit substrate 1c and the second circuit substrate 2c form the integrated structure, to facilitate assembly of the packaging device 500. In addition, the first thermally conductive layer 13a and the second thermally conductive layer 23a are of the integrated structure, so that flatness of a connection interface when the packaging device 500 is subsequently assembled with a heat dissipation apparatus is improved, a risk that a gap occurs on the connection interface is reduced, and heat dissipation efficiency of the packaging device 500 is further improved.

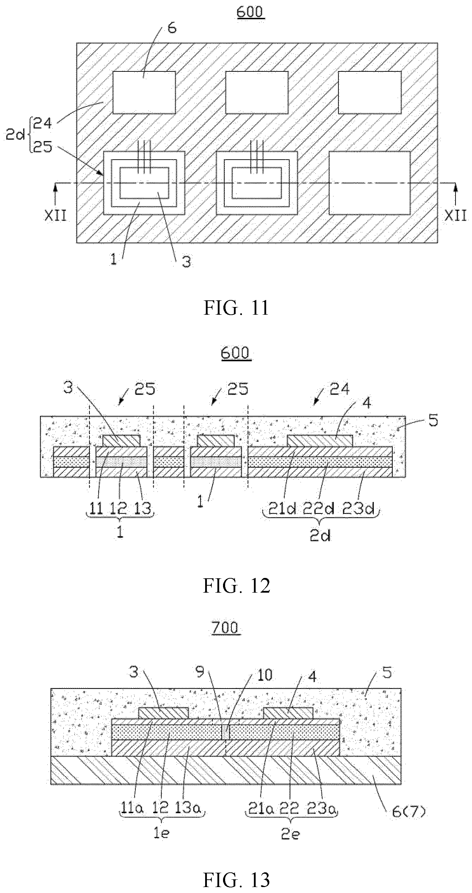

Refer to FIG. 11 and FIG. 12. The packaging device 600 includes a first circuit substrate 1 and a second circuit substrate 2d. The second circuit substrate 2d includes a second line layer 21d, a second insulation layer 22d, and a second thermally conductive layer 23d that are sequentially stacked. The second circuit substrate 2d further includes a circuit substrate body 24 and at least one opening 25 that penetrates the circuit substrate body 24. A second electronic component 4 is located on the circuit substrate body 24, and at least one first circuit substrate 1 is disposed in each opening 25.

In some embodiments, the opening 25 may be formed on the circuit substrate body 24 through mechanical opening or laser opening.

In the packaging device 600 although a thermal conductivity of the second insulation layer 22d is low, but a price is low. The second circuit substrate 2d is used as a whole, and the opening 25 is formed on the second circuit substrate 2d. The first circuit substrate 1 with a high thermal conductivity is embedded in the opening 25, and this helps improve a heat dissipation capability of the packaging device 600 and reduce costs of the packaging device 600. In addition, the second circuit substrate 2d is used as a whole, and the second line layer 21d may complete forming of lines in different areas through one etching, thereby simplifying an etching process. There is no need to solder conducting wires between the different areas of the second line layer 21d, thereby improving reliability of the packaging device 600. In addition, the second circuit substrate 2d is used as a whole, so that flatness and stiffness are high. When the packaging device 600 is subsequently assembled with a heat dissipation apparatus, a risk of forming a gap between the heat dissipation apparatus and the first circuit substrate 1 and the second circuit substrate 2d can be effectively reduced, and heat dissipation efficiency of the packaging device 600 is further improved.

Refer to FIG. 13. Another example out of the scope of the invention provides a packaging device 700. A difference between the packaging device 700 and the packaging device 300 in the foregoing example lies in that the packaging device 700 includes a first circuit substrate 1e and a second circuit substrate 2e. The first circuit substrate 1e and the second circuit substrate 2e are of an integrated structure. The first circuit substrate 1e includes a first line layer 11a, a first insulation layer 12, and a first thermally conductive layer 13a that are sequentially stacked. The second circuit substrate 2e includes a second line layer 21a, a second insulation layer 22, and a second thermally conductive layer 23a that are sequentially stacked. The first insulation layer 12 and the second insulation layer 22 are connected together by using an adhesive layer 10 to form an integrated structure.

Compared with the foregoing example, in the packaging device 700 of this example, the first insulation layer 12 and the second insulation layer 22 further form the integrated structure, to facilitate assembly of the first circuit substrate 1e and the second circuit substrate 2e, and facilitate one-time etching of the first line layer 11a and the second line layer 21a. In addition, flatness of the first thermally conductive layer 13a and the second thermally conductive layer 23a that are integrated can be further improved, a risk that a gap occurs on a connection interface when the packaging device 700 is subsequently connected to a heat dissipation apparatus is reduced, and heat dissipation efficiency of the packaging device 700 is improved.

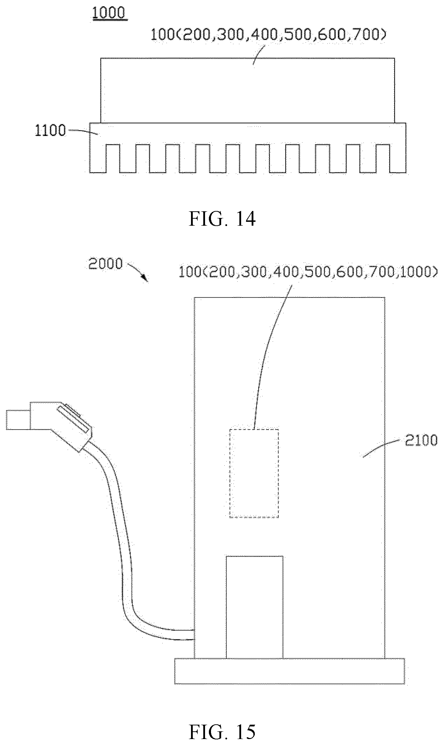

Refer to FIG. 14. With reference to FIG. 1 to FIG. 13, an embodiment of this application provides a packaging module 1000. The packaging module 1000 includes the foregoing packaging device 100 (200, 300, 400, 500, 600, 700) and at least one heat dissipation apparatus 1100. The at least one heat dissipation apparatus 1100 is located on a side that is of a first thermally conductive layer 13 (13a) and that is away from a first insulation layer 12 and/or on a side that is of a second thermally conductive layer 23 (23a, 23d) and that is away from a second insulation layer 22 (22d).

In some embodiments, when a surface that is of the first thermally conductive layer 13 (13a) and that is away from the first insulation layer 12 is coplanar with a surface that is of the second thermally conductive layer 23 (23a, 23d) and that is away from the second insulation layer 22 (22d), the packaging module 1000 includes one heat dissipation apparatus 1100. In this case, the heat dissipation apparatus 1100 is disposed on the surface that is of the first thermally conductive layer 13 (13a) and that is away from the first insulation layer 12 and the surface that is of the second thermally conductive layer 23 (23a, 23d) and that is away from the second insulation layer 22 (22d).

In another embodiment, when the surface that is of the first thermally conductive layer 13 (13a) and that is away from the first insulation layer 12 is not coplanar with the surface that is of the second thermally conductive layer 23 (23a, 23d) and that is away from the second insulation layer 22 (22d), the packaging module 1000 includes two heat dissipation apparatuses 1100. One heat dissipation apparatus 1100 is located on the surface that is of the first thermally conductive layer 13 (13a) and that is away from the first insulation layer 12, and the other heat dissipation apparatus 1100 is located on the surface that is of the second thermally conductive layer 23 (23a, 23d) and that is away from the second insulation layer 22 (22d).

In some embodiments, the heat dissipation apparatus 1100 may be directly disposed on the first thermally conductive layer 13 (13a) and the second thermally conductive layer 23 (23a, 23d). It may be understood that the heat dissipation apparatus 1100 may be directly connected to the first thermally conductive layer 13 (13a) and the second thermally conductive layer 23 (23a, 23d) or may be attached to surfaces of the first thermally conductive layer 13 (13a) and the second thermally conductive layer 23 (23a, 23d) by using thermally conductive adhesive.

In another embodiment, the heat dissipation apparatus 1100 may alternatively be indirectly connected to the first thermally conductive layer 13 (13a) and the second thermally conductive layer 23 (23a, 23d) by using a first thermally conductive component 6 and a second thermally conductive component 7. It may be understood that the heat dissipation apparatus 1100 may be directly connected to the first thermally conductive component 6 and the second thermally conductive component 7, or may be indirectly connected by using the thermally conductive adhesive. Heat dissipation efficiency of the packaging device 100 (200, 300, 400, 500, 600, 700) can be further improved by adding the heat dissipation apparatus 1100. In addition, positions of a first circuit substrate 1 (1a, 1b, 1c, 1e) and a second circuit substrate 2 (2a, 2b, 2c, 2d, 2e) may be flexibly arranged, so that single-sided heat dissipation or double-sided heat dissipation may be implemented, to meet different requirements.

Refer to FIG. 15. An embodiment of this application provides an electronic device 2000. The electronic device 2000 includes a housing 2100 and the foregoing packaging device 100 (200, 300, 400, 500, 600, 700) or the foregoing packaging module 1000 that is located in the housing 2100. The electronic device 2000 may be a vehicle-mounted power supply, a photovoltaic inverter, a station energy source, an industrial motor drive, or the like. In this embodiment, the electronic device 2000 is an electric vehicle charging pile.

## Claims

1. A packaging device (100), comprising:
a first circuit substrate (1), comprising a first line layer (11) and a first insulation layer (12) that are sequentially stacked, wherein at least one first electronic component (3) is disposed on the first circuit substrate (1), and
a second circuit substrate (2), comprising a second line layer (21) and a second insulation layer (22) that are sequentially stacked, wherein at least one second electronic component (4) is disposed on the second circuit substrate (2), and
a thermal conductivity of the first insulation layer (12) is higher than a thermal conductivity of the second insulation layer (22),
wherein the second circuit substrate (2) comprises a circuit substrate body (24) and at least one opening (25) that penetrates the circuit substrate body (24), and at least one first circuit substrate (1) is disposed in each opening (25).

2. The packaging device (100) according to claim 1, wherein the second line layer (21) is electrically connected to the first line layer (11) through a conducting wire (8); or
the first line layer (11) is electrically connected to the second line layer (21) by using an electrical connection layer (9), and the first line layer (11), the second line layer (21), and the electrical connection layer (9) are of an integrated structure.

3. The packaging device (100) according to claim 1 or 2, wherein the first insulation layer (12) and the second insulation layer (22) are in contact with each other.

4. The packaging device (100) according to claim 1 or 2, wherein the first insulation layer (12) and the second insulation layer (22) are of an integrated structure.

5. The packaging device (100) according to any one of claims 1 to 4, wherein a material of the first insulation layer (12) comprises AlN or Si₃N₄, and a material of the second insulation layer (22) comprises Al₂O₃.

6. The packaging device (100) according to any one of claims 1 to 5, wherein the first circuit substrate (1) comprises a first thermally conductive layer (13) located on a surface that is of the first insulation layer (12) and that is away from the first line layer (11), and the second circuit substrate (2) comprises a second thermally conductive layer (23) located on a surface that is of the second insulation layer (22) and that is away from the second line layer (21).

7. The packaging device (100) according to claim 6, wherein a surface that is of the first thermally conductive layer (13) and that is away from the first insulation layer (12) is coplanar with a surface that is of the second thermally conductive layer (23) and that is away from the second insulation layer (22), and the first thermally conductive layer (13) and the second thermally conductive layer (23) are of an integrated structure.

8. The packaging device (100) according to claim 6, wherein a surface that is of the first thermally conductive layer (13) and that is away from the first insulation layer (12) is not coplanar with a surface that is of the second thermally conductive layer (23) and that is away from the second insulation layer (22), and the first thermally conductive layer (13) and the second thermally conductive layer (23) are disposed opposite to each other.

9. The packaging device (100) according to any one of claims 6 to 8, comprising a package body (5), wherein the package body (5) packages the first circuit substrate (1) and the second circuit substrate (2), and both the surface that is of the first thermally conductive layer (13) and that is away from the first insulation layer (12) and the surface that is of the second thermally conductive layer (23) and that is away from the second insulation layer (22) are exposed from the package body (5).

10. The packaging device (100) according to any one of claims 6 to 9, wherein a first thermally conductive component (6) is disposed on the surface that is of the first thermally conductive layer (13) and that is away from the first insulation layer (12), and a second thermally conductive component (7) is disposed on the surface that is of the second thermally conductive layer (23) and that is away from the second insulation layer (22).

11. The packaging device (100) according to claim 10, wherein when the surface that is of the first thermally conductive layer (13) and that is away from the first insulation layer (12) is coplanar with the surface that is of the second thermally conductive layer (23) and that is away from the second insulation layer (22), the first thermally conductive component (6) and the second thermally conductive component (7) are of an integrated structure.

12. A packaging module (1000), comprising the packaging device (100) according to any one of claims 1 to 11 and at least one heat dissipation apparatus (1100), wherein the at least one heat dissipation apparatus (1100) is located on a side that is of a first insulation layer (12) and that is away from a first line layer (11) and/or on a side that is of a second insulation layer (22) and that is away from a second line layer (21).

13. An electronic device (2000), comprising a housing (2100) and the packaging device (100) according to any one of claims 1 to 11 or the packaging module (1000) according to claim 12 that is located in the housing (2100).

## Patentansprüche

1. Verpackungsvorrichtung (100), umfassend:
ein erstes Schaltungssubstrat (1), das eine erste Leitungsschicht (11) und eine erste Isolierschicht (12) umfasst, die sequentiell gestapelt sind, wobei mindestens ein erstes elektronisches Bauelement (3) auf dem ersten Schaltungssubstrat (1) angeordnet ist; und
ein zweites Schaltungssubstrat (2), das eine zweite Leitungsschicht (21) und eine zweite Isolierschicht (22) umfasst, die sequentiell gestapelt sind, wobei mindestens ein zweites elektronisches Bauelement (4) auf dem zweiten Schaltungssubstrat (2) angeordnet ist, und
eine Wärmeleitfähigkeit der ersten Isolierschicht (12) höher ist als eine Wärmeleitfähigkeit der zweiten Isolierschicht (22),
wobei das zweite Schaltungssubstrat (2) einen Schaltungssubstratkörper (24) und mindestens eine Öffnung (25) umfasst, die den Schaltungssubstratkörper (24) durchdringt, und mindestens ein erstes Schaltungssubstrat (1) in jeder Öffnung (25) angeordnet ist.

2. Verpackungsvorrichtung (100) gemäß Anspruch 1, wobei die zweite Leitungsschicht (21) über einen leitenden Draht (8) elektrisch mit der ersten Leitungsschicht (11) verbunden ist; oder
wobei die erste Leitungsschicht (11) elektrisch mit der zweiten Leitungsschicht (21) unter Verwendung einer elektrischen Verbindungsschicht (9) verbunden ist, und die erste Leitungsschicht (11), die zweite Leitungsschicht (21) und die elektrische Verbindungsschicht (9) aus einem integrierten Struktur bestehen.

3. Verpackungsvorrichtung (100) gemäß Anspruch 1 oder 2, wobei die erste Isolierschicht (12) und die zweite Isolierschicht (22) miteinander in Kontakt stehen.

4. Verpackungsvorrichtung (100) gemäß Anspruch 1 oder 2, wobei die erste Isolierschicht (12) und die zweite Isolierschicht (22) aus einem integrierten Struktur bestehen.

5. Verpackungsvorrichtung (100) gemäß einem der Ansprüche 1 bis 4, wobei ein Material der ersten Isolierschicht (12) AlN oder Si₃N₄ umfasst und ein Material der zweiten Isolierschicht (22) Al₂O₃ umfasst.

6. Verpackungsvorrichtung (100) gemäß einem der Ansprüche 1 bis 5, wobei das erste Schaltungssubstrat (1) eine erste wärmeleitende Schicht (13) umfasst, die sich auf einer Oberfläche befindet, die zu der ersten Isolationsschicht (12) gehört und die von der ersten Leitungsschicht (11) entfernt ist, und das zweite Schaltungssubstrat (2) eine zweite wärmeleitende Schicht (23) umfasst, die sich auf einer Oberfläche befindet, die zu der zweiten Isolationsschicht (22) gehört und die von der zweiten Leitungsschicht (21) entfernt ist.

7. Verpackungsvorrichtung (100) gemäß Anspruch 6, wobei eine Oberfläche, die zu der ersten wärmeleitenden Schicht (13) gehört und die von der ersten Isolierschicht (12) entfernt ist, koplanar mit einer Oberfläche ist, die zu der zweiten wärmeleitenden Schicht (23) gehört und die von der zweiten Isolierschicht (22) entfernt ist, und die erste wärmeleitende Schicht (13) und die zweite wärmeleitende Schicht (23) aus einer integrierten Struktur bestehen.

8. Verpackungsvorrichtung (100) gemäß Anspruch 6, wobei eine Oberfläche, die zu der ersten wärmeleitenden Schicht (13) gehört und die von der ersten Isolierschicht (12) entfernt ist, nicht koplanar mit einer Oberfläche ist, die zu der zweiten wärmeleitenden Schicht (23) gehört und die von der zweiten Isolierschicht (22) entfernt ist, und die erste wärmeleitende Schicht (13) und die zweite wärmeleitende Schicht (23) einander gegenüberliegend angeordnet sind.

9. Verpackungsvorrichtung (100) gemäß einem der Ansprüche 6 bis 8, umfassend einen Paketkörper (5), wobei der Paketkörper (5) das erste Schaltungssubstrat (1) und das zweite Schaltungssubstrat (2) verpackt und sowohl die Oberfläche, die zu der ersten wärmeleitenden Schicht (13) gehört und die von der ersten Isolationsschicht (12) entfernt ist, als auch die Oberfläche, die zu der zweiten wärmeleitenden Schicht (23) gehört und die von der zweiten Isolationsschicht (22) entfernt ist, von dem Paketkörper (5) freiliegen.

10. Verpackungsvorrichtung (100) gemäß einem der Ansprüche 6 bis 9, wobei ein erstes wärmeleitendes Bauelement (6) auf der Oberfläche angeordnet ist, die zu der ersten wärmeleitenden Schicht (13) gehört und die von der ersten Isolierschicht (12) entfernt ist, und ein zweites wärmeleitendes Bauelement (7) auf der Oberfläche angeordnet ist, die zu der zweiten wärmeleitenden Schicht (23) gehört und die von der zweiten Isolierschicht (22) entfernt ist.

11. Verpackungsvorrichtung (100) gemäß Anspruch 10, wobei das erste wärmeleitende Bauelement (6) und das zweite wärmeleitende Bauelement (7) aus einer integrierten Struktur bestehen, wenn die Oberfläche, die zu der ersten wärmeleitenden Schicht (13) gehört und die von der ersten Isolierschicht (12) entfernt ist, koplanar mit der Oberfläche ist, die zu der zweiten wärmeleitenden Schicht (23) gehört und die von der zweiten Isolierschicht (22) entfernt ist.

12. Verpackungsmodul (1000), umfassend die Verpackungsvorrichtung (100) gemäß einem der Ansprüche 1 bis 11 und mindestens ein Wärmeableitungsgerät (1100), wobei sich das mindestens eine Wärmeableitungsgerät (1100) auf einer Seite befindet, die zu einer ersten Isolationsschicht (12) gehört und von einer ersten Leitungsschicht (11) entfernt ist, und/oder auf einer Seite, die zu einer zweiten Isolationsschicht (22) gehört und von einer zweiten Leitungsschicht (21) entfernt ist.

13. Elektronische Vorrichtung (2000), umfassend ein Gehäuse (2100) und die Verpackungsvorrichtung (100) gemäß einem der Ansprüche 1 bis 11 oder das Verpackungsmodul (1000) gemäß Anspruch 12, das sich in dem Gehäuse (2100) befindet.

## Revendications

1. Dispositif d'encapsulation (100), comprenant :
un premier substrat de circuit (1), comprenant une première couche de ligne (11) et une première couche d'isolation (12) qui sont empilées séquentiellement, dans lequel au moins un premier composant électronique (3) est disposé sur le premier substrat de circuit (1) ; et
un second substrat de circuit (2), comprenant une seconde couche de ligne (21) et une seconde couche d'isolation (22) qui sont empilées séquentiellement, dans lequel au moins un second composant électronique (4) est disposé sur le second substrat de circuit (2), et
une conductivité thermique de la première couche isolante (12) est supérieure à une conductivité thermique de la seconde couche isolante (22),
dans lequel le second substrat de circuit (2) comprend un corps de substrat de circuit (24) et au moins une ouverture (25) qui pénètre dans le corps de substrat de circuit (24), et au moins un premier substrat de circuit (1) est disposé dans chaque ouverture (25).

2. Dispositif d'encapsulation (100) selon la revendication 1, dans lequel la seconde couche de ligne (21) est connectée électriquement à la première couche de ligne (11) par un fil conducteur (8) ; ou
la première couche de ligne (11) est connectée électriquement à la seconde couche de ligne (21) en utilisant une couche de connexion électrique (9), et la première couche de ligne (11), la seconde couche de ligne (21), et la couche de connexion électrique (9) sont d'une structure intégrée.

3. Dispositif d'encapsulation (100) selon la revendication 1 ou 2, dans lequel la première couche isolante (12) et la seconde couche isolante (22) sont en contact l'une avec l'autre.

4. Dispositif d'encapsulation (100) selon la revendication 1 ou 2, dans lequel la première couche isolante (12) et la seconde couche isolante (22) sont d'une structure intégrée.

5. Dispositif d'encapsulation (100) selon l'une quelconque des revendications 1 à 4, dans lequel un matériau de la première couche isolante (12) comprend AlN ou Si₃N₄, et un matériau de la seconde couche isolante (22) comprend Al₂O₃.

6. Dispositif d'encapsulation (100) selon l'une quelconque des revendications 1 à 5, dans lequel le premier substrat de circuit (1) comprend une première couche thermoconductrice (13) située sur une surface qui est de la première couche d'isolation (12) et qui est éloignée de la première couche de ligne (11), et le second substrat de circuit (2) comprend une seconde couche thermoconductrice (23) située sur une surface qui est de la seconde couche d'isolation (22) et qui est éloignée de la seconde couche de ligne (21).

7. Dispositif d'encapsulation (100) selon la revendication 6, dans lequel une surface qui est de la première couche thermoconductrice (13) et qui est éloignée de la première couche isolante (12) est coplanaire avec une surface qui est de la seconde couche thermoconductrice (23) et qui est éloignée de la seconde couche isolante (22), et la première couche thermoconductrice (13) et la seconde couche thermoconductrice (23) sont d'une structure intégrée.

8. Dispositif d'encapsulation (100) selon la revendication 6, dans lequel une surface qui est de la première couche thermoconductrice (13) et qui est éloignée de la première couche isolante (12) n'est pas coplanaire avec une surface qui est de la seconde couche thermoconductrice (23) et qui est éloignée de la seconde couche isolante (22), et la première couche thermoconductrice (13) et la seconde couche thermoconductrice (23) sont disposées à l'opposé l'une de l'autre.

9. Dispositif d'encapsulation (100) selon l'une quelconque des revendications 6 à 8, comprenant un corps d'encapsulation (5), dans lequel le corps d'encapsulation (5) encapsule le premier substrat de circuit (1) et le second substrat de circuit (2), et la surface qui est de la première couche thermoconductrice (13) et qui est éloignée de la première couche d'isolation (12) et la surface qui est de la seconde couche thermoconductrice (23) et qui est éloignée de la seconde couche d'isolation (22) sont exposées à partir du corps d'encapsulation (5).

10. Dispositif d'encapsulation (100) selon l'une quelconque des revendications 6 à 9, dans lequel un premier composant thermoconducteur (6) est disposé sur la surface qui est de la première couche thermoconductrice (13) et qui est éloignée de la première couche isolante (12), et un second composant thermoconducteur (7) est disposé sur la surface qui est de la seconde couche thermoconductrice (23) et qui est éloignée de la seconde couche isolante (22).

11. Dispositif d'encapsulation (100) selon la revendication 10, dans lequel lorsque la surface qui est de la première couche thermoconductrice (13) et qui est éloignée de la première couche isolante (12) est coplanaire avec la surface qui est de la seconde couche thermoconductrice (23) et qui est éloignée de la seconde couche isolante (22), le premier composant thermoconducteur (6) et le second composant thermoconducteur (7) sont d'une structure intégrée.

12. Module d'encapsulation (1000), comprenant le dispositif **d'encapsulation** (100) selon l'une quelconque des revendications 1 à 11 et au moins un appareil de dissipation de chaleur (1100), dans lequel l'au moins un appareil de dissipation de chaleur (1100) est situé sur un côté qui est d'une première couche d'isolation (12) et qui est éloigné d'une première couche de ligne (11) et/ou sur un côté qui est d'une seconde couche d'isolation (22) et qui est éloigné d'une seconde couche de ligne (21).

13. Dispositif électronique (2000), comprenant un boîtier (2100) et le dispositif d'encapsulation (100) selon l'une quelconque des revendications 1 à 11 ou le module **d'encapsulation** (1000) selon la revendication 12 qui est situé dans le boîtier (2100).
